# EUROPEAN PATENT APPLICATION

(11) **EP 4 560 693 A1**
(43) Date of publication of application: **28.05.2025**
(21) Application number: 24212076.4
(22) Date of filing: 11.11.2024
(51) Int. Cl.: H01L 23/15, H01L 23/498, H01L 23/538, H05K 1/03, H05K 1/18, H05K 3/00, H05K 3/46

(54) **PACKAGING SUBSTRATE AND MANUFACTURING METHOD OF PACKAGING SUBSTRATE**

(30) Priority: 23.11.2023 US 202363602435 P
(71) Applicant: Absolics Inc., Covington, GA 30014 (US)
(72) Inventor: LEE, Bongyeol, Covington, Georgia, 30014 (US)
(74) Representative: BCKIP Part mbB

(57) **Abstract**

An embodiment relates to a manufacturing method of a packaging substrate and a packaging substrate utilizing the same. A packaging substrate according to the present disclosure includes a core layer, the core layer comprising: a glass core having first and second surfaces facing each other; a cavity portion having a surface recessed to open in the direction of the first surface; and a plurality of core vias penetrating the glass core in a thickness direction, the glass core comprising a first glass and a second glass laminated up and down, the first glass and the second glass having a bonding interface disposed between them, and the tapered angle of the cavity portion may be from 86 degrees to 90 degrees.

## Description

This application claims the priority of U.S. Provisional Patent Application No. 63/602,435, filed November 23, 2023.

### BACKGROUND

### 1. Field

The embodiments relate to a packaging substrate, a semiconductor package, a manufacturing method for a packaging substrate.

### 2. Description of Related Art

When building an electronic component, implementing the circuitry on a semiconductor wafer is called the Front-End (FE), and assembling the wafer into a product-ready state is called the Back-End (BE). The latter includes the packaging process.

The four core technologies of the semiconductor industry that have enabled the rapid development of electronic products in recent years are semiconductor technology, semiconductor packaging technology, manufacturing process technology, and software technology.

Semiconductor technology is advancing in many ways, including sub-micron to nanoscale linewidths, more than 10 million cells, high-speed operation, and significant heat dissipation, but the technology to package them perfectly is still relatively new.

Therefore, the electrical performance of a semiconductor is often determined by the packaging technology and its electrical connections rather than the performance of the semiconductor technology itself.

Substrates for packaging can be made of ceramic or resin. Ceramic substrates, such as silicon substrates, have high resistivity or high dielectric constant, making it difficult to mount high-performance, high-frequency semiconductor devices. In the case of resin substrates, it is possible to mount relatively high-performance, high-frequency semiconductor devices. However, there are limitations in reducing the pitch of the wiring.

Recently, silicon or glass can be used as substrates for high-end packaging. By forming through-holes in the silicon or glass substrate and applying conductive materials to the through-holes, the wiring between the element and the motherboard can be shortened thereby improving electrical characteristics.

Relevant prior art includes Chinese Patent Application Publication CN 114171491 A and European Patent Application Publication EP 4152365 A2.

### SUMMARY

An objective of the embodiments is to provide a manufacturing method of a packaging substrate that applies a glass core and a packaging substrate. The packaging substrate includes a glass core produced by joining at least 2 glasses in an anodic bonding process.

It is also an objective of the embodiments to provide a manufacturing method of an element packaging substrate including a glass substrate having a core via having an inflection point at which a side angle changes when viewed in cross-section by joining at least 2 glasses by an anodic bonding process, and a packaging substrate using the same.

To accomplish the above objectives, one embodiment is directed to a packaging substrate and a manufacturing method of a packaging substrate.

A packaging substrate according to one or more embodiments includes a core layer, the core layer comprising: a glass core having first and second surfaces facing each other; a cavity portion having a surface recessed to open in the direction of the first surface; and a plurality of core vias penetrating the glass core in a thickness direction, wherein the glass core comprises a combination of a first glass and a second glass laminated up and down.

A bonding interface is disposed between the first glass and the second glass.

The tapered angle of the cavity portion may be 86 degrees to 90 degrees.

An individual core via, when viewed in cross-section, comprises: a first opening abutting the first surface; a second opening abutting the second surface; a lateral line connecting the first opening and the second opening along an inner diameter surface of the individual core via; and an inflection point at which the lateral line changes angle.

The inflection point of the core via may substantially be at the bonding interface.

The lateral line may have one or more inflection points or three or more inflection points.

A cavity core via is a via disposed of in the cavity portion.

The cavity core via includes, when viewed in cross-section, an individual cavity core via having: a first opening abutting a bottom surface of the cavity portion; a second opening abutting a second surface of the cavity portion; a lateral line connecting the first opening and the second opening along an inner diameter surface of the individual core via; and an inflection point at which the lateral line bends at some angle.

The lateral line of the cavity core via may include one or more inflection points.

The bonding interface may be an anodic bonded interface.

The glass core may have a thickness of 500 µm or more.

A cavity portion is disposed in the first glass, wherein the cavity portion may correspond to a recessed surface or a penetrated portion of the first glass.

Electronic elements may be arranged in the inner space of the cavity portion.

In the inner space of the cavity portion, an element module may be disposed that one or more electronic elements are arranged and molded.

A manufacturing method of a packaging substrate, according to one or more embodiments, including: a preparation operation of preparing a first glass having a recessed surface or penetrated portion and a plurality of core vias; a second glass having a plurality of core vias; and a bonding operation of aligning the first glass and the second glass and bonding them with an anodic bonding process to produce a glass core.

The core layer, the components thereof having the characteristics described above.

The manufacturing method of the packaging substrate, further comprising: a wiring operation of forming a rewiring layer on the first surface or the second surface after the bonding operation.

The manufacturing method of the packaging substrate, further comprising: an inserting operation of inserting an element into the cavity after the bonding operation.

### BRIEF DESCRIPTION OF THE DRAWINGS

FIG. 1 is a conceptual diagram illustrating a cross-sectional structure of a packaging substrate, according to an embodiment.
FIG. 2 is a conceptual diagram illustrating a cross-sectional structure of a packaging substrate, according to another embodiment.
(a) and (b) of FIG. 3 are conceptual diagrams illustrating a cross-sectional view of a portion of a packaging substrate, according to an embodiment, respectively.
FIG. 4 is a cross-sectional flowchart illustrating a process for creating a core distribution layer during the manufacturing of a packaging substrate, according to an embodiment.
FIG. 5 is a cross-sectional flowchart illustrating a process for creating an insulating layer during the manufacturing of a packaging substrate, according to an embodiment.
FIG. 6 is a cross-sectional view illustrating a process for generating a glass core having a half-cavity, according to an embodiment.
FIGS. 7A through 7C are conceptual diagrams illustrating a cross-sectional view of a core layer comprising a glass core with a half-cavity created in accordance with an embodiment.
FIG. 8 is an exemplary cross-sectional conceptual view of the packaging substrate of FIG. 7B with the glass core.

### DETAILED DESCRIPTION

In order to provide a comprehensive understanding of the methods, apparatus, and/or systems described herein, the following detailed description is provided. However, various modifications, revisions, and equivalents of the methods, devices, and/or systems described herein will become apparent after understanding what this disclosure presents. For example, the sequence of operations described herein is by way of example only and is not intended to be limiting to the operations described herein. With the exception of operations that are not necessarily performed in a particular order, the order of operations may be altered based on an understanding of what is disclosed herein. Furthermore, descriptions of features already known in the art may be omitted for clarity and brevity after understanding the disclosure of this application. However, the omission of such features and their descriptions is not intended to be recognized as common general knowledge.

The features described herein may be implemented in different forms and are not to be construed as being limited to the examples described herein. Rather, the embodiments described herein are provided to illustrate some of the many possible ways of implementing the methods, devices, and/or systems described herein that will become apparent after understanding the disclosures of this application.

The terms "first," "second," "third," and the like may be used herein to describe various members, components, regions, layers, or sections, but are not intended to limit the members, components, regions, layers, or sections to these words. Instead, these terms are used for the purpose of distinguishing one member, component, region, layer, or section from another member, component, region, layer, or section. Thus, a first member, component, region, layer, or section referred to in the embodiments described herein may also be referred to as a second member, component, region, layer, or section without departing from the teachings of the embodiments.

Throughout the specification, when an element, such as a layer, region, or substrate, is described as being "on," "connected to," or "coupled to" another element, it may be described as being directly "on," "connected to," or "coupled to" the other element, or it may have one or more other elements interposed between them. In contrast, when an element is described as "directly on", "directly connected to", or "directly joined to" another element, no other element can intervene between them. Similarly, for example, expressions such as "between" and "directly between," and "abutting" and "directly abutting" can also be interpreted as described above.

The terms used in this specification are intended to describe specific examples and are not intended to limit disclosure. The singular form used herein is intended to include the plural form unless the context clearly indicates otherwise. As used herein, the term "and/or" includes any one or a combination of two or more of the relevant list items. The terms "comprising," "consisting of," and "having" as used herein specify the presence of the specified features, numbers, actions, elements, components, and/or combinations thereof, but do not exclude the presence or addition of one or more other features, numbers, actions, elements, components, and/or combinations thereof. The use of the term "may" in this specification with respect to an example or embodiment (e.g., with respect to what an example or embodiment may include or implement) implies that there is at least one example or embodiment that includes or implements such features, but not all examples are limited thereto.

For the purposes of this application, "B being located on A" means that B is placed on top of A, either in direct contact with A or with another layer or structure interposed therebetween, and should not be construed to mean that B is in direct contact with A.

Unless otherwise defined, all terms used herein shall have the same meaning as commonly understood by one of ordinary skill in the art to which the present invention belongs. Such terms, as defined in commonly used dictionaries, shall be construed to have a meaning consistent with their meaning in the context of the prior art and the present invention and shall not be construed in an idealized or overly formal sense unless expressly defined herein.

In one or more of the examples above, a description of "A and/or B" means "A, B, or A and B".

In one or more of the above examples, terms such as "first," "second," "A," or "B" are used to distinguish identical terms from each other.

In one or more of the above examples, a singular form is contextually interpreted to include the plural as well as the singular, unless otherwise noted.

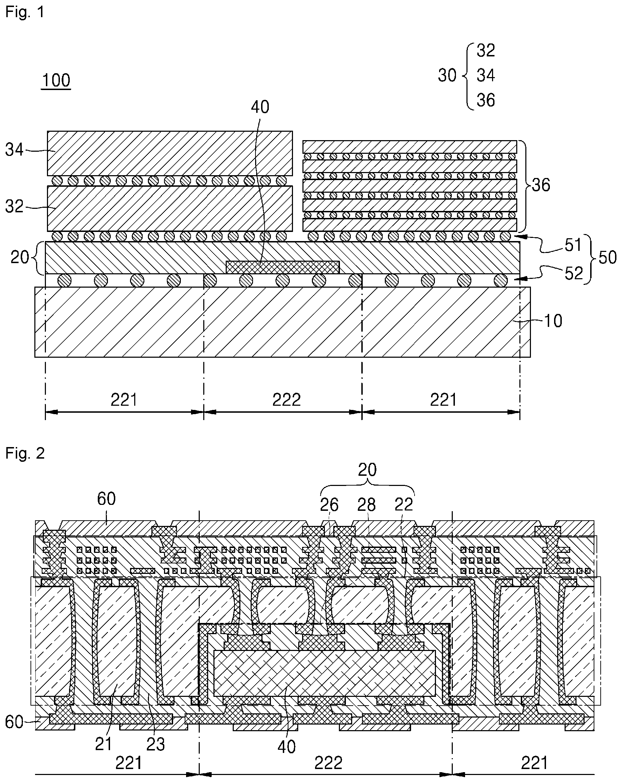

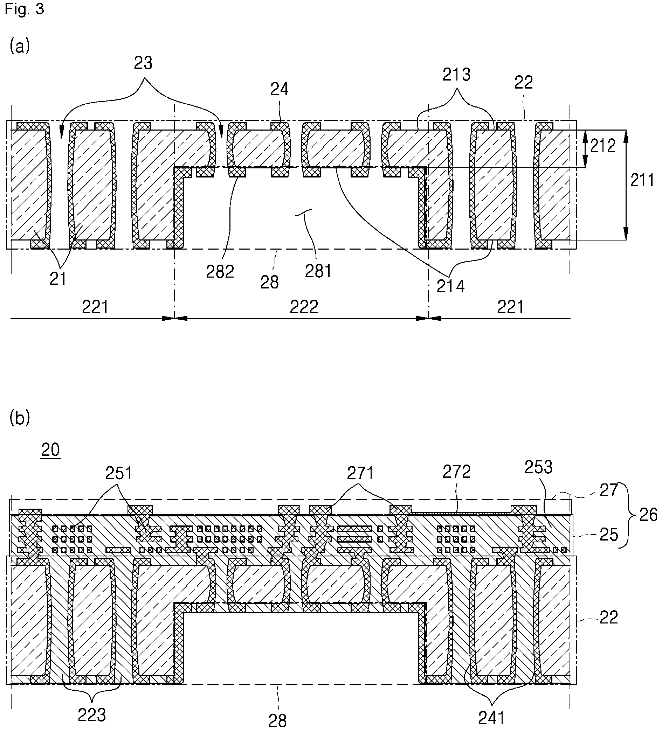

FIG. 1 is a conceptual diagram illustrating a cross-sectional structure of a packaging substrate according to an embodiment, FIG. 2 is a conceptual diagram illustrating a cross-sectional structure of a packaging substrate according to another embodiment, and (a) and (b) of FIG. 3 are conceptual diagrams illustrating cross-sections of portions of a packaging substrate according to embodiments, respectively.

To accomplish the above objectives, a semiconductor device 100 according to an embodiment comprises a semiconductor element portion 30 on which one or more semiconductor elements 32, 34, 36 are located; a packaging substrate 20 electrically connected to the semiconductor elements; and a motherboard 10 electrically connected to the packaging substrate 20 and transmitting external electrical signals to and connecting the semiconductor elements 32, 34, 36 with each other.

The packaging substrate 20, according to one embodiment, comprises a core layer 22, an upper layer 26 positioned on a first surface of the core layer 22, and a cavity portion 28 in which an electronic element 40 may be located.

The semiconductor element portion 30 refers to an element mounted on a semiconductor device and is mounted on the packaging substrate 20 by means of a connection electrode or the like. Specifically, semiconductor element portion 30 may be applied to, for example, a computing element (first element: 32, second element: 34) such as a CPU or GPU, a memory element (third element, 36) such as a memory chip, etc.

The motherboard 10 may be a motherboard such as a printed circuit board, a printed wiring board, or the like.

The packaging substrate 20 may optionally further comprise a lower layer (not shown) located below the core layer.

The core layer 22 comprisese a first zone 221 having a first thickness 211 and a second zone 222 having a second thickness 212 adjacent to the first zone 221 and less than the first thickness; a plurality of core vias 23 penetrating the glass core 21 in a thickness direction and a core distribution layer 24 located on a surface of the glass core 21 or core vias 23 and electrically connecting, via the core vias 23, a first surface 213 of the glass core 21 and a second surface 214 facing the first surface 213.

The second zone 222 of the core layer 22 may serve as a cavity structure.

Within the same zone, the glass core 21 has a first surface 213 and a second surface 214 that face each other, and these two faces are substantially parallel to each other and have a substantially constant thickness throughout the glass core 21.

The inner space 281 formed by the difference in thickness of the first zone 221 and the second zone 222 serves to house some or all of the electronic elements 40.

The glass core 21 may comprise core vias 23 penetrating the first surface 213 and the second surface 214. The core vias 23 may be formed in both the first zone 221 and the second zone 222 and may be formed in any desired pitch and pattern.

As a packaging substrate for semiconductor devices, silicon substrates and organic substrates have traditionally been applied in a laminated form. In the case of silicon substrates, due to the nature of semiconductors, parasitic elements may occur when applied to high-speed circuits, and power losses are relatively high. In addition, organic substrates require a large area to form more complex distribution patterns, which is inconsistent with the trend of miniaturization of electronic devices. In order to form a complex distribution pattern within a certain size, pattern refinement is practically necessary, but there were practical limitations in pattern refinement due to the characteristics of materials such as polymers applied to organic plates.

In an embodiment, the glass core 21 is applied as support for the core layer 22 for solving these problems. In addition, a core via 23 formed through and around the glass core 21 is applied in conjunction with the glass core 21 to provide a packaging substrate 20 having shorter electrical flow lengths, a more miniaturized, faster response, and lower loss characteristics.

The glass core 21 may preferably be a glass substrate applied to a semiconductor, for example, a borosilicate glass substrate, an alkali-free glass substrate, and the like, but is not limited thereto.

The core via 23 penetrates the glass core 21. The core via 23 may be formed by removing a predetermined area of the glass core 21, in particular by etching the plate glass by physical and/or chemical means.

Specifically, the formation of the core via 23 may be accomplished by forming defects (inclusions) on the surface of the glass core, such as by laser or the like, followed by chemical etching, laser etching, and the like, but is not limited to these methods.

The core vias 23 may be 100 to 3,000 in number, 100 to 2,500 in number, 225 to 1,024 in number, or 225 to 1,024 in number based on a unit area (1 cm x 1 cm) of the glass core 21. When these pitch conditions are met, the formation of an electrically conductive layer or the like and the performance of the packaging substrate can be improved.

The core distribution layer 24 comprises a core distribution pattern 241, an electrically conductive layer electrically connecting the first and second surfaces of the glass core 21 via through vias, and a core insulation layer 223 surrounding the core distribution pattern. The core layer 22 has an electrically conductive layer formed therein through the core vias, which acts as an electrical pathway across the glass core 21 and may connect the upper and lower parts of the glass core over a relatively short distance, resulting in faster electrical signal transmission and low loss. The electrically conductive layer may be, for example, but not limited to, a copper plating layer.

The cavity portion 28 is substantially circular, triangular, square, hexagonal, octagonal, cross-shaped, or otherwise non-limiting in shape.

The electronic element 40 may be generally cylindrical, cuboidal, or polygonal in shape.

The cavity portion 28 may comprise a cavity distribution pattern, which is an electrically conductive layer electrically connecting the electronic element 40 and the core distribution layer 24, and an insulating layer surrounding the cavity distribution pattern.

Alternatively, the cavity portion according to another embodiment may be implemented in a form that penetrates the first surface 213 and the second surface 214 of the glass core 21. In this case, the cavity portion may be formed according to the same process as the formation process of the core vias 23 and may differ from the core vias 23 in the area and shape through the glass core 21.

In such an embodiment, an insulating layer may be created in the cavity portion after the electronic element 40 is arranged in the cavity portion, i.e., an insulating layer may be created in the cavity portion through the process of creating the core insulation layer 223 described above.

The core distribution pattern 241 may be patterned to be electrically coupled to the electronic element 40.

The electronic element 40 may comprise an active element, such as a transistor, or a passive element, such as a power transfer element, such as a multilayer ceramic capacitor (MLCC).

For example, when an element such as a transistor, which plays a role in converting electrical signals between the motherboard and the semiconductor element portion to an appropriate level, is applied to the electronic element 40, the packaging substrate 20 may become a form in which a transistor or the like is applied in the path of the packaging substrate 20, thereby providing a semiconductor device 100 having more efficient and faster speed.

In addition, power transfer elements, such as multilayer ceramic capacitors (MLCCs), play an important role in the performance of semiconductor devices. It is common for at least 200 or more power transfer elements, which are passive elements, to be applied to a semiconductor device, and their performance in transferring power is also affected by the characteristics of the electrically conductive layer surrounding the element. In one embodiment, non-circular shaped core via may be applied where a low resistance electrically conductive layer is required, such as in power transfer devices.

On the other hand, the electronic element 40 may be applied by inserting passive elements such as capacitors individually, or it may be embedded between insulator layers (electronic device insulation layers) in such a way that a group of elements comprising a plurality of passive elements is formed so that the electrodes are exposed and then inserted into the electronic device. The latter option is more workable for packaging substrate fabrication and more favorable for ensuring that the insulating layer is sufficiently and reliably located in the space between complex elements.

The glass core 21 plays an intermediate role, an intermediary role, connecting the semiconductor component 30 and the motherboard 10 on the upper and lower sides, respectively, and the core via 23 acts as a passageway for transmitting electrical signals therebetween, thereby facilitating smooth signal transmission. For the purpose of distinguishing from the core via of the second zone 222 described later, the core via disposed in the first zone 221 will be referred to as the first zone core via 231.

The upper layer 26 is above the first surface 213.

The upper layer 26 may comprise a top distribution layer 25 and a top-surface contact layer 27 located on the top distribution layer 25, and the uppermost surface of the upper layer 26 may be protected by a cover layer 60 having an opening formed through which the contact electrodes of the semiconductor element can directly contact.

The top distribution layer 25 comprises an upper insulation layer 253 positioned on the first surface; and a top distribution pattern 251 embedded in the upper insulation layer 253 as an electrically conductive layer having a predetermined pattern and electrically connecting at least a portion thereof with the core distribution layer 24. The top distribution layer 25 disposed above and below each other may be connected to each other via blind via 252.

The upper insulation layer 253 may be applied as an insulator layer to a semiconductor element or packaging substrate, and may be, for example, an epoxy-based resin containing fillers, but is not limited to this.

The insulator layer may be formed by forming a coating layer and curing it, or it may be formed by laminating an uncured or semi-cured insulator film to the core layer 22 and curing it. In this case, by applying a pressure-sensitive lamination method or the like, the insulator may be embedded into the space inside the core vias 23, and the process may proceed efficiently.

In some embodiments, the plurality of insulating layers may be stacked and substantially indistinguishable from one another, and the plurality of insulating layers are collectively referred to as the upper insulation layer. Additionally, the core insulation layer 223 and the top insulation layer 253 may be made of the same insulating material, in which case the boundary between them may be substantially indistinguishable. Alternatively, in other implementations, the boundaries of the insulator layers may be created by setting different pressures and temperatures to cure the multiple insulator layers.

The top distribution pattern 251 refers to an electrically conductive layer located within the upper insulation layer 253 in a preset shape, which may be formed, for example, in a buildup layer method. Specifically, the top distribution pattern 251 may be formed by forming an insulator layer, removing an unnecessary portion of the insulator layer, forming an electrically conductive layer by copper plating or the like, optionally removing an unnecessary portion of the electrically conductive layer, forming an insulator layer on top of the electrically conductive layer, removing an unnecessary portion of the insulator layer, forming an electrically conductive layer by plating or the like, and so on, so that the electrically conductive layer is formed in a vertical or horizontal direction in the desired pattern.

Since the top distribution pattern 251 is located between the core layer 22 and the semiconductor element portion 30, it is formed to comprise a fine pattern in at least a portion thereof so that the transmission of electrical signals to the semiconductor element portion 30 can proceed smoothly and the intended complex pattern can be sufficiently accommodated. In this case, the fine patterns may have a width and spacing of less than 4 µm, 3.5 µm or less, 3 µm or less, 2.5 µm or less, or 2.3 µm or less. The width and spacing may be 1 µm or more (hereinafter, the description of the fine patterns will be the same).

The top-surface contact layer 27 comprises a top surface connection pattern 272 electrically connected, at least partially, with the top distribution pattern 251 and located on the upper insulation layer 253, and a top-surface contact electrode 271 electrically connecting the top surface connection pattern 272 with the semiconductor element portion 30.

The top surface connection pattern 272 may be located on a first surface of the upper insulation layer 253, or at least a portion thereof may be exposed and embedded in the upper insulation layer 253. For example, if the top surface connection pattern is located on one side of the upper insulation layer, the upper insulation layer may be formed by plating or the like, and if the top surface connection pattern is embedded with a part of it exposed on the upper insulation layer, it may be that a part of the insulating layer or the electrically conductive layer is removed by surface polishing, surface etching, or the like after forming a copper plating layer or the like.

The top surface connection pattern 272 may comprise at least a portion of a fine pattern, such as the top distribution pattern 251 described above. The top surface connection pattern 272 comprising such fine patterns enables a larger number of devices to be electrically connected in a smaller area, allowing for smoother electrical signal connections between devices or to the outside world, and more integrated packaging.

The top-surface contact electrode 271 may be directly connected to the semiconductor element portion 30 by terminals or the like or may be connected via an element connection 51 such as a solder ball.

The cavity portion 28 comprises a cavity distribution layer 282 located above and/or below the second zone 222 and electrically connected to the core distribution pattern 241, and an inner space 281 in which the electronic elements 40 are located.

Specifically, the second zone 222 has a thinner thickness of the glass core 21 compared to the first zone 221, and the electronic element 40 may be located in the inner space 281 formed due to the difference in thickness. Furthermore, the core vias 23 and the core distribution layer 24 formed in the glass core 21 serve as an electrical connection structure connecting the electronic element 40 and the external element.

Furthermore, as described above, a cavity portion may be created in the form of penetrating the first zone 221, i.e., the first surface 213 and the second surface 214 of the glass core 21, rather than the second zone 2212, and the electronic element 40 may be arranged in the cavity portion.

The packaging substrate 20 is also connected to a motherboard 10. The motherboard 10 may be electrically connected to the core distribution pattern 241 located on at least a portion of the second surface 214 of the core layer 22 by terminals of the motherboard 10, either directly or via a board connection 52 such as a solder ball. In addition, the core distribution pattern 241 abutting the motherboard 10 may be connected to the motherboard 10 via a lower layer (not shown) located at the bottom of the core layer 22.

In one example, no substantially additional substrate other than the glass core 21 may be applied to the packaging substrate 20 positioned between the semiconductor element portion 30 and the motherboard 10.

Traditionally, the interposer and organic substrate are laminated together between the element and the motherboard. There are at least two reasons for this multi-operation application: one is that there are scale issues with directly bonding the fine pattern of the element to the motherboard, and the other is that wiring damage may occur during the bonding process or during the driving process of the semiconductor device due to differences in thermal expansion coefficients.

The embodiment solves this problem by applying a glass core with a coefficient of thermal expansion similar to that of a semiconductor device and forming a fine pattern on the first surface of the glass core and its upper layer with a scale fine enough for element mounting.

In the following, a method for manufacturing a packaging substrate according to an embodiment of the present invention will be described.

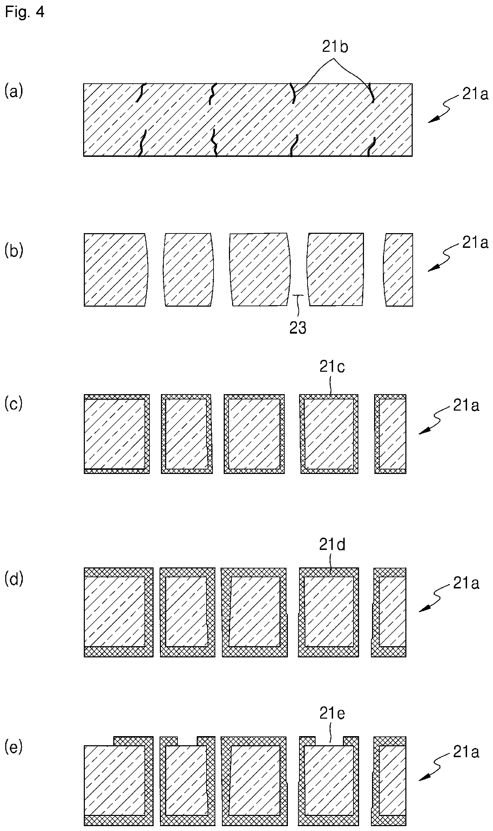

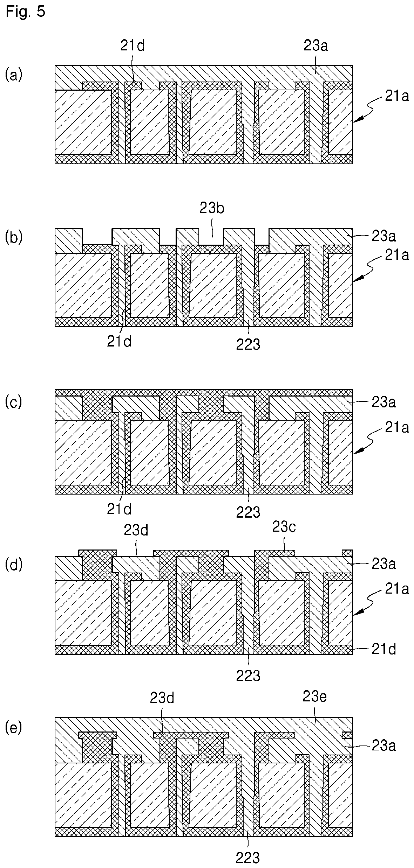

FIGS. 4 and 5 are flowcharts illustrating, in cross-section, the manufacturing process of a packaging substrate according to an embodiment.

First, a glass core 21a having a flat first and second surfaces is prepared, as shown in (a) of FIG. 4, and a defect (groove, 21b) is formed on the glass surface at a predetermined position for forming a core via 23. The glass may be a glass core applied to a substrate of an electronic device or the like, and for example, an alkali-free glass core may be applied, but is not limited thereto. Commercially available products manufactured by manufacturers such as Corning, Schott, AGC, and the like may be applied. The defects (grooves) may be formed by mechanical etching, laser irradiation, or the like.

As shown in (b) of FIG. 4, the glass core 21a in which the defect (groove, 21b) is formed is subjected to an etching operation to form a core via 23 through a physical or chemical etching process. During the etching process, the glass core 21 forms vias in the defect portion and at the same time, the surface of the glass core 21a may be etched. A masking film or the like may be applied to prevent such etching of the glass surface, but the defective glass core itself may be etched into consideration of the cumbersome process of applying and removing the masking film, and in such a case, the thickness of the glass core having the core via may be somewhat thinner than the thickness of the initial glass core.

Then, the core layer preparation operation may be performed by forming an electrically conductive layer 21d on the glass core as shown in (c) and (d) of FIG. 4. The electrically conductive layer may be a metal layer including, but not limited to, copper metal.

The surface of the glass (comprising the surface of the glass core and the surface of the core via) and the surface of the copper metal have different properties, and the adhesion between them is poor. In an embodiment, the adhesion between the glass surface and the metal can be improved by two methods, a dry method and a wet method.

The dry method is a method of applying sputtering, that is, metal sputtering, to form a seed layer 21c on the surface of the glass and the inner diameter of the core via. In the formation of the seed layer, dissimilar metals such as titanium, chromium, nickel, and the like may be sputtered together with copper, and in this case, glass-to-metal adhesion may be improved by an anchor effect in which the surface morphology of the glass and the metal particles interact.

The wet method is a primer treatment method in which a primer layer 21c is formed by pretreatment with a compound having functional groups such as amines. Depending on the degree of adhesion desired, pretreatment with a silane coupling agent may be followed by primer treatment with a compound or particle having an amine functional group. As mentioned above, the support substrate of the embodiment needs to be of high enough performance to form a fine pattern, which should be maintained after the primer treatment. Therefore, if such primer comprises nanoparticles, it is preferred that nanoparticles having an average diameter of 150 nm or less are applied, for example, particles having amine functional groups. The primer layer may be formed by applying a bonding force improver, for example, such as the CZ series of MEC.

The seed layer/primer layer 21c may optionally form the electrically conductive layer with or without removing the portion where the formation of the electrically conductive layer 21d is unnecessary. Furthermore, the seed layer/primer layer 21c may be optionally treated in an activated or deactivated state for metal plating with or without removing the portion where the formation of the electrically conductive layer is necessary or unnecessary to proceed with the subsequent process. For example, the activation or deactivation treatment may be subjected to light irradiation treatment such as a laser of a certain wavelength, chemical treatment, or the like. The formation of the metal layer may comprise, but is not limited to, copper plating methods applied in the manufacture of semiconductor devices.

As shown in (e) of FIG. 4, a portion of the core distribution layer 24 may be removed if it is unnecessary, and after the seed layer is partially removed or inactivated, metal plating may be performed to form an electrically conductive layer in a predetermined pattern to form the etch layer 21e of the core distribution layer 24.

FIG. 5 illustrates manufacturing operations to form an insulating layer and an upper layer pattern, according to one embodiment.

As shown in (a) of FIG. 5, the core via 23 may be subjected to an insulating layer formation operation in which the void space is filled with an insulating layer after the formation of the core distribution layer 24, which is an electrically conductive layer. In this case, the insulating layer applied may be made in the form of a film, for example, by pressure sensitive lamination of the insulating layer in the form of a film. By performing such pressure-sensitive lamination, the insulating layer may be sufficiently impregnated into the void space inside the core vias 23 to form a core insulating layer without void formation.

Operations (b) through (e) of FIG. 5 illustrate the upper layer manufacturing operations.

The operation of manufacturing the upper layer is to form an upper layer comprising an upper insulating layer and an upper layering pattern on the core layer. The upper insulating layer may be formed by coating a resin composition forming the insulating layer 23a or by laminating an insulating film, and the simplest method is to laminate an insulating film. The lamination of the insulating film may be carried out by laminating the insulating film and curing it, in which case, by applying a pressure sensitive lamination method, the insulating resin may be sufficiently impregnated even to a layer in which no electrically conductive layer is formed inside the core via 23. The upper insulating layer 23a is also applied in direct contact with the glass core, at least in part, and thus has sufficient adhesion. Specifically, the glass core and the upper insulating layer are preferably characterized by an adhesion test value of 4B or more according to ASTM D3359.

The upper layer pattern may be formed by repeating the process of forming the insulating layer 23a, forming the electrically conductive layer 23c in a predetermined pattern, and etching off the unnecessary parts to form the etching layer 23d of the electrically conductive layer. Alternatively, in the case of the electrically conductive layers that are formed adjacent to the insulating layer, a blind via 25b may be formed on the insulating layer prior to proceeding with the plating process. Dry etching methods such as laser etching, plasma etching, and the like, or wet etching methods using a masking layer and an etching solution, may be applied to form the blind via.

Then, although not shown, a top surface contact layer and a cover layer may be formed.

The top surface connection pattern and the top surface contact electrode may also be formed by a process similar to the formation of the upper layer. Specifically, it may be formed by forming an etch layer in the insulating layer on the insulating layer 23e, forming an electrically conductive layer thereon, forming an etched layer in the electrically conductive layer, and so on, but it may also be applied by selectively forming only the electrically conductive layer without applying the method of etching. The cover layer may be formed such that an opening (not shown) is formed at a position corresponding to the top surface contact electrode so that the top surface contact electrode is exposed and can be directly connected to an electrical connection or a terminal of the element.

Once the upper layer has been created, the lower layer may be processed by forming the bottom contact layer and cover layer. The lower layer and/or the bottom contact layer, and optionally the cover layer (not shown), may be formed in a similar manner to the operations for forming the top contact layer and cover layer described above.

As described above, the core layer may comprise a glass core, wherein the glass core may be a glass substrate having first and second surfaces facing each other. Further, as described above, the glass core may comprise a cavity.

The cavity may be open in the direction of the first surface or the second surface to provide a space for an electrical element to be recessed or penetrated through the glass core. The cavity may be open in the direction of the first surface or the second surface of the glass core to provide an internal space for an electrical element to be recessed or penetrated through the glass core.

The cavity portion having an internal space that is recessed by opening in the first or second direction may be referred to as a half cavity, and the cavity portion having an internal space that is recessed by opening in the first or second direction may be referred to as a half cavity, and the cavity portion having an internal space penetrating the glass core may be referred to as a full cavity. An electronic element may be arranged in the inner space of the cavity portion.

In order to produce a glass core having a half cavity, the following methods are conventionally used. For example, in a conventional technique for producing a half cavity, a method utilizing a single sheet of glass may be used to selectively irradiate the glass with energy such as laser to produce a half cavity. In this case, a tapered zone with increasingly narrower gaps may be created at the edge of the cavity, and the margin region may be widened. As a result, the device space available for mounting the electronics in the cavity may be reduced.

As another example, in a conventional technique for manufacturing a half cavity, a method of creating a half cavity by etching after two sheets of glass are glued together with an adhesive such as a polymer bond may be used. In this case, the repeated application of the distribution layer formation process to the glass core may cause the polymer adhesive to heat up and change over time to weaken the bonding strength of the polymer adhesive. Delamination may occur between the glass sheets forming the glass core.

Accordingly, embodiments of manufacturing a half cavity to address the problems described above are proposed herein.

A manufacturing method of a packaging substrate comprising a core layer, according to one or more embodiments, comprising: a preparation operation of preparing a first glass having a recessed surface or penetrated portion and a plurality of core vias; a second glass having a plurality of core vias; and a bonding operation of aligning the first glass and the second glass and bonding them with an anodic bonding process to produce a glass core.

The manufacturing method may further comprise: after the bonding operation, forming a rewiring layer on the first surface or the second surface. The rewiring layer may be formed by any of the methods described above, but is not limited thereto. The method may further comprise: inserting operation an element into the cavity after the bonding operation.

For example, a glass core may be created by providing one piece of glass having a full cavity and a plurality of core vias penetrating the glass in the thickness direction, another piece of glass having a plurality of core vias penetrating the glass in the thickness direction and aligning and bonding the first piece of glass with the second piece of glass. Optionally, the glasses may be aligned such that the plurality of core vias are aligned and penetrate in the direction of the glass core thickness, i.e., the vias of the first glass and the vias of the second glass. The present invention is exemplarily described with reference to the first glass having a full cavity, but it is also applicable to the first glass having a half cavity formed in the glass itself before bonding. It is also possible to have a full cavity in one glass before bonding and a half cavity in another glass before bonding.

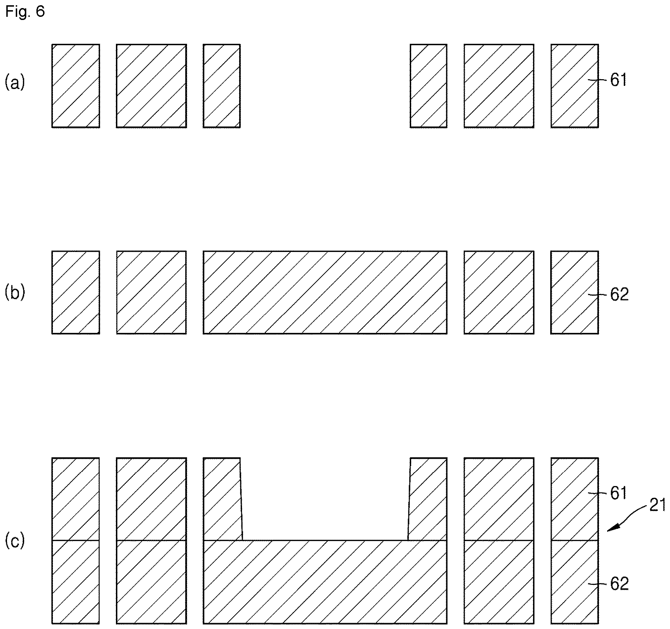

FIG. 6 is a cross-sectional view illustrating a process for generating a glass core having a half-cavity, according to an embodiment.

Referring to (a) in FIG. 6, there is provided a first glass 61 having a cavity portion and a plurality of core via penetrating the first glass 61. The first glass 61 having the cavity may be referred to as a cavity glass.

Referring to (b) of FIG. 6, the second glass 62 may have a plurality of core vias penetrating the second glass 62. The second glass 62 may also be a glass with no cavities formed. In this case, the second glass 62 may be referred to as a bare glass. Although not shown in FIG. 6, according to an embodiment, a half cavity may be formed in the second glass.

Then, referring to (c) of FIG. 6, after the first glass 61 and the second glass 62 are in place, the first glass 61 and the second glass 62 may be aligned and bonded to create a glass core 21. The glass core 21 may comprise a half cavity recessed in the direction of the first surface or the second surface and a plurality of core via penetrating the glass core 21 in the thickness direction. The bonding is preferably by an anodic bonding process. Anodic bonding will be described later.

The glass core 21 is described in more detail below.

For example, the inner space of the cavity portion may be at a specific angle relative to the first surface or the second surface when viewed in cross-section. For example, the specific angle may be 90 degrees (or 89 degrees to 90 degrees). The angle of the side of the inner space of the cavity portion may have a tapered angle, wherein the gap becomes narrower in the thickness direction.

Electronic elements may be arranged in the inner space of the cavity portion. The electronic element 40 may be inserted and arranged in the inner space of the cavity portion. For example, an adhesive paste such as PI tape (Polyimide Tape) on the bottom surface of the cavity portion may or may not be attached, and an electronic element may be selected and arranged in the inner space of the cavity portion (designation of the position of the electronic element). Alternatively, an element group comprising a plurality of electronic elements in a form embedded between an insulator layer (electronic element insulation layer) may be formed to expose an electrode and inserted into the inner space of the cavity portion. The electronic element 40 may comprise an active element, such as a transistor, or a passive element, such as a power transfer element, such as a multilayer ceramic capacitor (MLCC).

Further, for example, the core via may comprise a first opening abutting a first surface of the glass core 21, a second opening abutting a second surface of the glass core 21, and an inflection point at which the angle of the side changes when viewed in cross-section in the entire core via connecting the first opening and the second opening. In addition, for example, the core via may comprise a first section in which the angle of the sides is at a first angle relative to the first or the second surface when viewed in cross-section, a second section in which the angle of the sides is inclined at a second angle relative to the first or the second surface when viewed in cross-section, and an inflection point connecting the first and second sections. Further, for example, the core via may comprise four or six or more inflection points, and there may be no limitation on the distance from the surface of the glass core (the first surface or the second surface) to the inflection points. Alternatively, for example, the core via may comprise two or more inflection points, and the distance from the surface of the glass core (the first surface or the second surface) to the inflection point may be 300 µm or less. The distance may be 50 µm or more.

The first glass 61 and the second glass 62 may each be made of a plate glass that is independently applied to a semiconductor process. In addition, the first glass 61 and the second glass 62 may each independently be made of a plate glass having the following characteristics.

At least one of the first glass 61 and the second glass 62 may have a amount of Na₂O₃ in the glass of 2.5 wt% or more, 3 wt% or more, or 3.5 wt% or more. Further, the amount of Na₂O₃ in the glass may be 6 wt% or less. When a glass having such an amount of Na₂O₃ is applied to at least one of the first glass 61 and the second glass 62, an anodic bonding may be easily applied.

The first glass 61 and the second glass 62 may each have a maximum use temperature of 240 °C or higher, 250 °C or higher, 260 °C or higher, 280 °C or higher, or 300 °C or higher, and the maximum use temperature may be 600 °C or lower, 580 °C or lower, or 560 °C or lower. In such cases, it may have sufficient thermal durability during manufacturing and operation.

Preferably, the first glass 61 and the second glass 62 have a linear thermal expansion coefficient α in °C that is substantially the same or has a negligible difference. The linear thermal expansion coefficient may be from 2.8*10^-6 to 4.5*10^-6, or from 3*10^-6 to 4*10^-6.

Preferably, the first glass 61 and the second glass 62 have excellent chemical resistance. Specifically, the weight loss per unit area (cm^2) may be 2 mg or less or 1.5 mg or less when immersed in a 10 wt% hydrofluoric acid solution at 23 °C for 20 minutes. Specifically, immersion in a 5 wt% sodium hydroxide solution at 95 °C for 6 hours may result in a weight loss of 0.5 mg or less or 0.3 mg or less per unit area (cm^2).

At least one of the first glass 61 and the second glass 62 may have a thermal diffusivity of 0.02 cm^2/sec or less, or 0.01 cm^2/sec or less. The thermal diffusivity may be greater than or equal to 0.0001 cm^2/sec. The application of a glass with a lower thermal diffusivity may help to facilitate the application of processes such as lamination.

At least one of the first glass 61 and the second glass 62 may be, for example, but not limited to, Corning 7740 (Pyrex), Schott Glass Borofloat, and the like.

The thickness of the first glass 61 and the thickness of the second glass 62 may be 200 µm or more, 300 µm or more, 400 µm or more, or 500 µm or more. The thicknesses may be 1,000 µm or less each.

The glass core 21 produced by bonding the first glass 61 and the second glass 62 by an anodic bonding process or the like may form a bonding interface between the first glass 61 and the second glass 62. By applying an anodic bonding process or the like, it is characterized in that the bonding strength at the bonding interface is strong enough to substantially prevent delamination problems at the interface.

The anodic bonding process is a bonding process that seals the glasses without introducing an intermediate layer, such as a polymeric bonding composition, between the glasses being joined.

At the interface, molecular bonds of Si and O located in the first and second glasses, respectively, are induced, resulting in a fairly strong interfacial bonding force, which may be sufficiently maintained even after repeated high-temperature processes that may be applied in the process of forming the glass core or packaging substrate, and the reliability of the product may be substantially maintained. The problem of delamination of the glass of the glass core 21 at the interface may be substantially prevented.

In other words, the glass core 21 comprises a molecular bond of Si and O at the interface between the first glass 61 and the second glass 62. This may be induced by an anodic bonding process.

Anodic bonding is a process that utilizes electricity, heat, and pressure to join the interfaces of laminated materials. The process may be performed with equipment such as, but not limited to, the SB-6E Bonder or EVG 520IS. The anodic bonding process may be performed as follows 1) Place the surfaces to be bonded, which have been leveled and cleaned, against each other. In an embodiment, a laminate is prepared with a first glass and a second glass placed face to face. 2) Raise the temperature of the laminate and apply a voltage. The temperature may be, for example, about 180 °C to about 500 °C, but may be adjusted according to the characteristics of the glass. The voltage may be about 200 V to about 1000 V. The voltage may be applied. The voltage may be a DC voltage. At the above temperature and voltage, the glass is activated and charges such as sodium ions are allowed to move along with the voltage. At this time, the metal atoms (e.g., silicon) on the surface of the other glass and the oxygen atoms in the activated glass can meet each other to form interatomic bonds, and a strong bonding effect can be achieved by the formation of metal oxides at the interface. In addition, since a separate polymer adhesive layer is not applied, there is virtually no possibility of issues such as particles in the semiconductor manufacturing process, and the metal oxide formed at the interface by anodic bonding substantially overlaps with the components of the glass, making it easier to apply existing processes, such as the formation of vias during the etching operation.

The glass core having a half-cavity according to the embodiment described above generates a tapered zone at the edge of the cavity such that the gap becomes narrower in the thickness direction, so that the element margin may be widened compared to a conventional method of generating a glass core using a single sheet of glass. This is advantageous for the pick-and-place tolerance of arranging the electronic elements, while leaving less space for the electronic elements to move after the pick-and-place process to prevent the electronic elements from deviating from the specified arrangement position. In addition, the glass core may be bonded to create a relatively thick glass core with a bonding interface, which reduces the occurrence of SeWaRe, a defect that occurs during the manufacturing of multiple layers of RDL. Furthermore, if the glass core 21 is created by joining the first glass 61 and the second glass 62 by an anodic bonding process, the interfacial bonding force is strong, so that the reliability does not deteriorate even with repeated high-temperature processes. In other words, it is possible to prevent problems such as weakening of the bonding force or delamination due to hardness changes in the bonding layer due to repeated application of high-temperature processes such as lamination processes.

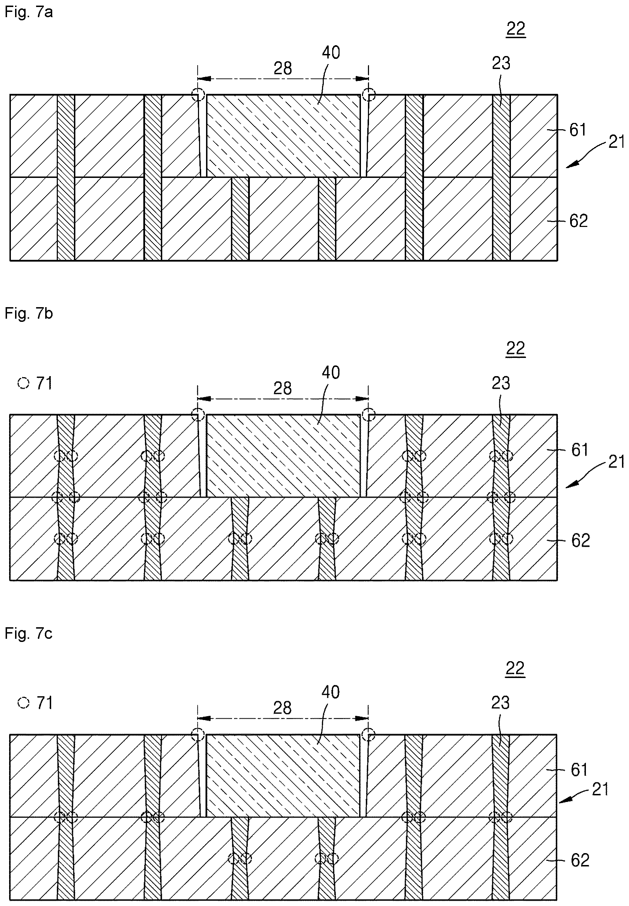

FIGS. 7A through 7C are exemplary conceptual diagrams illustrating, in cross-section, a core layer comprising a glass core having a half-cavity created in accordance with embodiments.

Referring to FIG. 7 A, the core layer 22 may comprise a glass core 21 having first and second surfaces facing each other, a cavity portion 28 recessed in the direction of the first or the second surface, and a plurality of core vias 23 penetrating the glass core 21 in a thickness direction.

Referring to FIG. 7a, the glass core 21 may comprise a first glass 61 and a second glass 62. The first glass 61 may comprise a through portion corresponding to the cavity and a plurality of core vias. The second glass 62 may comprise a plurality of core vias through the second glass 62. The plurality of core vias of the first glass 61 and the plurality of core via of the second glass 62 may be connected to each other in a predetermined manner to form a core via penetrating the glass core 21.

The glass core 21 may be bonded to the first glass and the second glass to form a bonding interface, which may be abbreviated as an interface. Alternatively, for example, the bonding interface may comprise a bonding layer. The bonding layer may be a Si-O bonding layer or a Si-O-Si bonding layer. For example, an O-Si-O structure in which Si/Si of the first glass and O of the second glass are bonded may be arranged at the bonding interface.

Furthermore, referring to FIG. 7a, the glass core 21 having first and second surfaces facing each other may be divided into a first zone (bare zone) having a first thickness, and a second zone (cavity zone) having a second thickness, where the cavity portion is located and is thinner than the first thickness.

The thickness of the first zone is referred to as the first thickness, and the thickness of the second zone is referred to as the second thickness. For example, the first thickness of the glass core 21 may be 400 µm or more, 500 µm or more, 600 µm or more, or 700 µm or more. The first thickness may be 1500 µm or less, 1400 µm or less, 1300 µm or less, 1200 µm or less, 1100 µm or less, or 1000 µm or less. The second thickness may be 200 µm or more, 300 µm or more, 400 µm or more, or 500 µm or more. The second thickness may be 1000 µm or less. However, the second thickness is smaller than the first thickness. In this case, a glass core can be provided in which warpage of the core layer is reduced.

Furthermore, for example, the inner space of the cavity portion may be angled at a particular angle with respect to the first surface or the second surface when viewed in cross-section. This particular angle is referred to as a tapered angle. For example, the particular angle may be 86 degrees or more, 87 degrees or more, 88 degrees or more, or 89 degrees or more. The particular angle may be 92 degrees or less, 91 degrees or less, or 90 degrees or less. The inner space of the cavity portion may have a tapered width in the thickness direction. The tapered angle refers to an angle measured along the inner space from the first surface to the side of the cavity portion, when viewed at 90 degrees to a line substantially perpendicular to the first or second surface of the glass core.

Further, for example, referring to FIG. 7a, an electronic element 40 may be disposed in the inner space 281 of the cavity portion 28. The electronic element 40 may be inserted into the inner space 281 of the cavity portion 28.

For example, an adhesive paste such as PI tape (Polyimide Tape) may or may not be attached to the bottom surface of the cavity portion, and an electronic element may be selected and disposed in the inner space of the cavity portion (designation of the position of the electronic element). Alternatively, an element group (element module) comprising a plurality of electronic elements in a form embedded between an insulator layer (electronic element insulation layer) may be formed so that the electrodes are exposed and inserted into the inner space of the cavity portion. The electronic elements 40 may comprise active elements, such as transistors, or passive elements, such as power transfer elements, such as multilayer ceramic capacitors (MLCCs).

In the inner space of the cavity formed in the glass core according to the above embodiment, the angles of the sides of the inner space of the cavity are embedded in such a way that the gap becomes narrower and narrower in the thickness direction, so that the element margin may be maintained, which is advantageous for the pick-and-place tolerance of arranging the electronic elements, but the space for the electronic elements to move after the pick-and-place process is small, which prevents the electronic elements from leaving the designated arrangement position.

Referring to FIG. 7B, the core layer 22 may comprise a glass core 21 having first and second surfaces facing each other, a recessed cavity portion 28 (illustrated as opening in the first surface direction, but not limited to opening in the second surface direction, and combinations thereof), and a plurality of core vias 23 penetrating the glass core 21 in a thickness direction.

Referring to FIG. 7B, the glass core 21 may comprise a cavity portion in which a first surface portion of the glass core is recessed and a plurality of core vias through the glass core. The specific description of the first and second glasses being joined, their respective interfaces, thicknesses, tapered angles, elements disposed in the cavity, and the like, is equally applicable to the description given above, and detailed description is omitted.

Also, for example, referring to FIG. 7B, the core via comprises, when viewed in cross-section, an individual core via comprising: a first opening abutting the first surface; a second opening abutting the second surface; a lateral line connecting the first opening and the second opening along an inner diameter surface of the individual core via; and an inflection point at which an angle changes at the lateral line. FIG. 7B illustrates three inflection points in a core via disposed in the first zone (bare zone), but zero inflection points (substantially no inflection points are observed, in the form of FIG. 7A). It may also be implemented with one (in the form of FIG. 7C, described later), or the like.

In various embodiments, the inflection points may be disposed at one or more, two or more, or three or more.

The inflection points of the core via through the glass core disposed in the first zone (bare zone) of the glass core 21 may be located substantially at the same height as each other. This helps to facilitate control when forming a conductive layer or the like in the core vias.

At least one of the inflection points of the core via disposed in the first zone (bare zone) of the glass core 21 may be disposed flush with the bonding interface.

The height refers to the height measured along the thickness direction of the glass core with respect to the second surface.

The distance from the surface of the glass core (the first surface or the second surface) to the inflection point may be 25% or less of the thickness of the glass core.

The distance from the surface of the glass core (the first surface or the second surface) to the inflection point may be 100 µm or more, 150 µm or more, or 200 µm or more, and may be 900 µm or less, 800 µm or less, or 700 µm or less. Also, the distance may be 550 µm or less, 450 µm or less, or 350 µm or less. In such cases, it may be more advantageous to manufacture the core layer utilizing the glass core.

For example, the core via has a first section wherein the angle of the side is at a first angle relative to the first plane or the second plane when viewed in cross-section, a second section wherein the angle of the side is at a second angle relative to the first plane or the second plane when viewed in cross-section, a third section wherein the angle of the side is at a third angle relative to the first plane or the second plane when viewed in cross-section, and a fourth section wherein the angle of the side slopes at a fourth angle relative to the first or the second section when viewed in cross-section, and may comprise a first inflection point connecting the first section to the second section, a second inflection point connecting the second section to the third section, and a third inflection point connecting the third section to the fourth section. The first angle, the second angle, the third angle, and the fourth angle may each be an angle of -10 degrees or more, -8 degrees or more, or -6 degrees or more relative to an imaginary line perpendicular to the plane of the second plane. It may also be +10 degrees or less, +8 degrees or less, or +6 degrees or less. Here, + refers to an angle in the inward direction of the core via from the vertical imaginary line, and - refers to an angle in the glass direction.

A core via disposed in the cavity, the core via being a cavity core via, the cavity core via comprising, when viewed in cross-section, an individual cavity core via having: a first opening abutting a bottom surface of the cavity; a second opening abutting a second surface of the cavity; a lateral line connecting the first opening and the second opening along an inner diameter surface of the individual core via; and an inflection point at which the lateral line changes angle.

The lateral line of the cavity core via may have one or more points of inflection.

The height of at least one of the inflection points of the core via disposed in the first zone (bare zone) may be substantially equal to the height of the inflection point of the cavity core via. In this case, the determination of whether the heights are substantially the same may be determined based on whether a position difference between inflection points is within an error range. In this case, the error range may be within 10% or within 5% of the length of the side line located in the bare area (in this specification, the same applies to determining whether the heights are substantially the same).

Referring to FIG. 7C, the core layer 22 may comprise a glass core 21 having first and second surfaces facing each other, a cavity portion 28 recessed in the direction of the first or the second surface, and a plurality of core vias 23 penetrating the glass core 21 in a thickness direction.

For example, in the embodiment of FIG. 7c, the specific description of the glass core 21, the first glass 61, the second glass 62, the thickness, properties, etc. thereof, the cavity portion, a plurality of cavity portions, the characteristics of the cavity portion, the characteristics of the cavity portion, the characteristics of the bonding interface, the characteristics of the inflection point, etc. thereof, may be applied as described above, and the specific description is omitted.

The inflection point of a core via placed in the first zone (bare zone) may be substantially flush with the bottom surface of the cavity portion.

In the first zone (bare zone), the ratio of the height of the first surface to the height of the inflection point of the core via placed in the first zone may be substantially the same as the ratio of the height of the first surface (recessed to the bottom of the cavity) to the height of the inflection point of the cavity core via placed in the second zone (cavity zone).

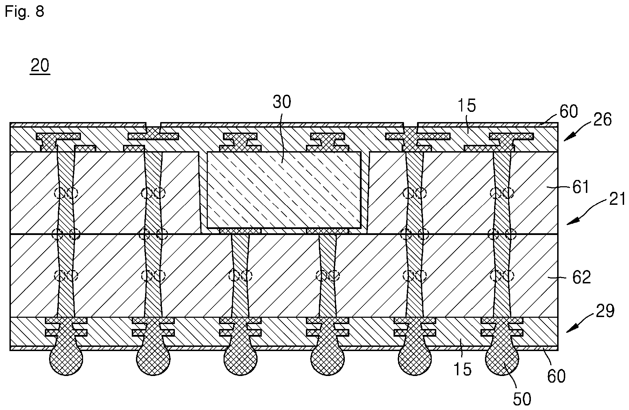

FIG. 8 is an exemplary cross-sectional conceptual view of the glass core packaging substrate of FIG. 7B.

Referring now to FIG. 8, the packaging substrate 20 may comprise a core portion comprising the glass core 21 described above, and an upper layer 26 and a lower layer 29 may be disposed on the core portion. FIG. 8 illustrates both an upper layer and a lower layer disposed thereon. Optionally, the upper layer 26 may be disposed and the lower layer 29 may not be disposed.

The upper layer and the lower layer are disposed with rewiring layers to allow electrical signals from the core to be transmitted to the upper and lower parts of the packaging substrate. FIG. 8 illustrates an exemplary packaging substrate with the glass core of FIG. 7B, but as described above, all of the above-mentioned features, comprising those described in FIGS. 1 through 5, are applicable.

The manufacturing method of a packaging substrate according to the embodiments described above and the packaging substrate utilizing the method can produce a thick glass core, thereby reducing the occurrence of SeWaRe, a defect that occurs during the manufacturing of multiple layers of RDL.

In addition, the manufacturing method of the packaging substrate according to the embodiments described above and the packaging substrate utilizing the method can strengthen the bonding force of the glasses forming the glass core having a half-cavity and prevent delamination of the glasses forming the glass core even after multiple high-temperature processes.

The manufacturing method of the packaging substrate of the embodiment and the packaging substrate using the same can maintain the element margin by generating a tapered zone at the edge of the cavity so that the gap is gradually narrowed in the thickness direction. This is advantageous for the pick and place tolerance of arranging electronic elements, but there is less space for electronic elements to move after the pick and place process, thereby preventing electronic elements from leaving the designated arrangement position.

In addition, the manufacturing method of the packaging substrate of the embodiment and the packaging substrate using it can create a thick glass core to reduce the occurrence of Seware, a defect that occurs in the manufacturing of multiple layers of RDL.

In addition, the manufacturing method of the packaging substrate of the embodiment and the packaging substrate using it can make it easier to manufacture a glass core with half-cavity and strengthen the bonding strength of the glass, preventing the glass forming the above glass core from being delaminated even in several high-temperature processes.

The above-described disclosure has been described with reference to the embodiments shown in the drawings, but these are exemplary only, and those having ordinary knowledge in the art will understand that various modifications and variations of the embodiments are possible from them. In other words, the scope of the disclosure is not limited to the embodiments described above, and various modifications and improvements by those skilled in the art utilizing the basic concepts of the embodiments defined in the following claims are also within the scope of the disclosure. Therefore, the true technical scope of the disclosure is to be determined by the technical ideas of the appended claims.

## Claims

1. A packaging substrate, comprising:
a core layer, wherein the core layer comprises:
a glass core having a first surface and a second surface facing each other;
a cavity portion having an inner space formed by recessing the surface to open in the direction of the first surface; and
a plurality of core vias penetrating the glass core in a thickness direction;
wherein the glass core comprises a first glass and a second glass laminated on top of the other and bonded together;
wherein a bonding interface is disposed between the first glass and the second glass; and
wherein the cavity portion has a tapered angle of 86 to 90 degrees.

2. The packaging substrate of claim 1,
wherein the core via, when viewed in cross-section, comprises an individual core via having:
a first opening abutting the first surface;
a second opening abutting the second surface;
a lateral line connecting the first opening and the second opening along an inner diameter surface of the individual core via; and
an inflection point at which the lateral line changes angle,
wherein the lateral line of the core via has an inflection point at the bonding interface.

3. The packaging substrate of claim 2,
wherein the lateral line has one or more inflection points, or three or more inflection points.

4. The packaging substrate of any one from claim 1 to claim 3,
wherein a core via disposed in the cavity portion is a cavity core via,
wherein the cavity core via, when viewed in cross-section, comprises an individual cavity core via having:
a first opening abutting a bottom surface of the cavity portion;
a second opening abutting the second surface;
a lateral line connecting the first opening and the second opening along an inner diameter surface of the individual core via; and
an inflection point at which the lateral line changes angle, and
wherein the lateral line of the cavity core via has one or more inflection points.

5. The packaging substrate of any one from claim 1 to claim 4,
wherein the bonding interface is an anodic bonding interface.

6. The packaging substrate of any one from claim 1 to claim 5,
wherein the thickness of the glass core is 500 µm or more.

7. The packaging substrate of any one from claim 1 to claim 6,
wherein the cavity portion is disposed in the first glass, and
the cavity portion is a recessed or penetrated portion of the first glass.

8. The packaging substrate of any one from claim 1 to claim 7,
wherein one or more electronic elements are arranged in the inner space of the cavity portion.

9. A manufacturing method of a packaging substrate comprising a core layer, the method comprising:
a preparation operation of preparing a first glass having a recessed surface or penetrated portion and a plurality of core vias and a second glass having a plurality of core vias; and
a bonding operation of aligning the first glass and the second glass and bonding them with an anodic bonding process to produce a glass core,
wherein the core layer comprises: a glass core having a first surface and a second surface facing each other; a cavity portion having a surface recessed to open in the direction of the first surface and defining an inner space; and a plurality of core vias penetrating the glass core in a thickness direction,
wherein the glass core comprises a first glass and a second glass laminated up and down and having a bonding interface disposed therebetween, and
wherein a tapered angle of the cavity portion is from 86 degrees to 90 degrees.

10. The manufacturing method of a packaging substrate of claim 9, further comprising: wiring operation of forming a redistribution layer on the first surface or the second surface after the bonding operation.

11. The manufacturing method of a packaging substrate of claim 9 or claim 10, further comprising: inserting operation of inserting an element into the cavity portion after the bonding operation,
wherein the element is in the form of an element module in which one or more electronic elements are arranged.
